# EUROPEAN PATENT APPLICATION

(11) **EP 2 928 059 A1**
(43) Date of publication of application: **07.10.2015**
(21) Application number: 13858243.2
(22) Date of filing: 21.10.2013
(51) Int. Cl.: H02M 7/48, H02K 11/00

(54) **INVERTER DEVICE AND INVERTER DEVICE INTEGRATED IN MOTOR**

(30) Priority: 28.11.2012 JP 2012259291
(71) Applicant: Hitachi Automotive Systems, Ltd., Hitachinaka-shi, Ibaraki 312-8503 (JP)
(72) Inventor: SUZUKI Kosuke, Hitachinaka-shi Ibaraki 312-8503 (JP); MIYAZAKI Hideki, Hitachinaka-shi Ibaraki 312-8503 (JP); KAWASHIMA Tetsuya, Tokyo 100-8280 (JP); OYAMA Kazuto, Hitachinaka-shi Ibaraki 312-8503 (JP)
(74) Representative: MERH-IP Matias Erny Reichl Hoffmann
(86) International application number: PCT/JP2013/078410
(87) International publication number: WO 2014/083964

(57) **Abstract**

An inverter device is configured such that a pull-out direction for a direct current cable to be connected an external power source is adjustable without modifying the shape of a motor and the shape of the inverter device body, thereby reducing the packaging volume including the direct current cable. To this end, a DC bus bar 96 that connects a smoothing capacitor 90 to semiconductor modules 500a to 500c is provided with two pairs of positive and negative terminals 92a, 94a, 92b, and 94b to be connected to an external power source 30. The positive and negative terminals 92a and 94a and the positive and negative terminals 92b and 94b respectively project from different side surfaces of an inverter housing 110.

## Description

### TECHNICAL FIELD

The present invention relates to an inverter device having a power control function for a motor.

### BACKGROUND ART

An electric vehicle or a hybrid vehicle includes an on-board motor as a power source of the vehicle, and commonly includes an inverter device to control the power supplied to the motor. The inverter device includes a power module having a built-in power semiconductor device, for instance, IGBT, a drive circuit that drives the power module, a control circuit that controls the drive circuit, a DC bus bar, which is wiring for the power supplied from a battery, an AC bus bar, which is wiring for the power supplied to the motor, and a smoothing capacitor for smoothing current.

The hybrid vehicle includes a power combination mechanism that combines the power of a motor with the power of an engine. In contrast, the electric vehicle is powered only by a main motor. The output of the main motor is transmitted to the wheels through a speed reducer including a differential gear. For electric vehicles, a big current of several hundred Amperes (A) is used and the motor is always driven so that loss generated due to the electric resistance of an AC harness is also big.

To reduce this loss and heat generated as a result of this loss, it is effective to use an AC harness having a relatively large diameter. However, the AC harness having a larger diameter requires a larger space volume for laying the AC harness due to its poor flexibility.

The electromechanically integrated inverter device, in which a motor and an inverter device are integrated together, no longer needs an AC harness that connects the inverter device and the motor. This is advantageous in that the space volume for installing the AC harness is reduced. Another advantage is in that cost of AC harness can be reduced.

Many technologies relating to integration of a motor and an inverter device have been made public. For instance, PTL 1 discloses an example of an electric compressor, which includes an inverter box provided on the outer periphery of a motor housing and a planar section for discharging heat arranged in parallel with a control circuit in the inside of the inverter box and also includes a capacitor of the inverter device accommodated between the control circuit and the planar section for discharging heat. PTL 1 mainly discloses efficient use of the space of the inverter device and the method of cooling the capacitor.

On the other hand, for instance, PTL 2 discloses a technology by which a plurality of motors uses a common inverter device. PLT 2 discloses a structure in which a cooler is arranged between a power module and a capacitor and the motor and the inverter device are connected to each other detachably.

### CITATION LIST

### PATENT LITERATURE

PTL 1: JP 2011-157873 A
PTL 2: JP H10-248199 A

### SUMMARY OF INVENTION

### TECHNICAL PROBLEM

An inverter device integrated with a motor that has a connection section to be connected to an external power source facing toward the external power source side allows easy installment of a direct current cable. In contrast, an inverter device integrated with a motor that has a connection section to be connected to an external power facing in a direction other than toward the external power source disallows easy installment of a direct current cable since the cable needs to cross over the motor, etc.

PTL 1 discloses the configuration of the connection section to be connected to the direct current cable connecting the external power source and the inverter device to each other, which configuration allows the direct current cable to be pulled out in a pull-out direction selected from two directions, i.e., a direction perpendicular to the main axis of the motor and a direction along the main axis of the motor.

This configuration has two problems. That is, (1) in the inside of the inverter device, the direction of a control board provided with a connection section to be connected to a direct current cable needs to be modified upon installment so as to correspond to the selected one of two optional directions. (2) The inverter case has a different shape depending on the shape of the pulled out portion of the connection section. That is, the conventional configuration presupposes that a variety of inverters must be provided according to the pull-out direction of the connection section to the direct current cable.

Conventionally, individually designed parts and modules have been manufactured on demand. However, the recent motor vehicle industry actively promotes standardization of parts and modules, each of which is a combination of parts. Use of the standardized parts and modules by a plurality of different types of vehicles in common will increase mass-producibility and productivity to reduce cost for parts. To promote the standardization, any modification of shape, no matter how partial it may be, to increase the number of types of parts is inappropriate.

PTL 2 discloses the method of commonly using a single type of inverter device by a plurality of types of motors which are to be mechanically and electrically integrated. It also states the effect of standardization of parts. However, it states nothing about modification of the pull-out direction for the connection section to be connected to a direct current cable that connects the inverter device to the external power source.

The present invention is to solve this problem and has for its object to allow, in an inverter device, the pull-out direction of a direct current cable connected to an external power source to be modified without changing the shape of a motor and the shape of the inverter device body and thereby reduce the packaging volume including the direct current cable.

### SOLUTION TO PROBLEM

To this end, the present invention forms two pairs of positive and negative electrode terminals for connection to an external power source at a DC bus bar, which extends between a smoothing capacitor and a semiconductor module to connect them to each other. Each pair of the positive and negative electrode terminals projects from different side surfaces of an inverter housing.

### ADVANTAGEOUS EFFECTS OF INVENTION

According to the present invention, a pair of positive and negative electrode terminals, which is selected from two such pairs, is connected to a direct current cable that connects the terminals to an external power source. This allows reduction of the packaging volume including the direct current cable without changing the shape of a motor and the shape of the inverter device body.

### BRIEF DESCRIPTION OF DRAWINGS

[FIG. 1] A diagram showing a control brock of an electric vehicle.
[FIG. 2] A circuit diagram showing the construction of an inverter circuit.
[FIG. 3] An external perspective view showing an inverter device integrated with a motor according to Embodiment 1 of the present invention.
[FIG. 4] An external perspective view of a semiconductor module.
[FIG. 5] An external perspective view of a smoothing capacitor.
[FIG. 6] An external perspective view of a capacitor storage case.
[FIG. 7] A cross-sectional view of an inverter device integrated with a motor according to Embodiment 1.
[FIG. 8] An external perspective view showing the arrangement of a DC bus bar.
[FIG. 9] A diagram showing a configuration in which a DC connector is connected to first positive and negative terminals of an inverter device and Y-capacitor to cope with EMC is connected to second positive and negative terminals of the inverter device.
[FIG. 10] An external view of a DC connector.
[FIG. 11] An external view of a Y-capacitor.
[FIG. 12] An external view of a terminal cover for safety.
[FIG. 13] A diagram showing a configuration in which a DC connector is connected to first positive and negative terminals of an inverter device and an additional inverter device is connected to second positive and negative terminals of the inverter.
[FIG. 14] A diagram of a judgment system that confirms whether an inverter device and additional modules, such as a DC connector or a terminal cover for safety, are properly connected.
[FIG. 15] A diagram showing an inverter device and a motor integrated electrically and mechanically.

### DESCRIPTION OF EMBODIMENTS

Hereafter, inverter devices according to Embodiments 1 to 5 of the present invention are explained in detail with reference to the attached drawings.

### Embodiment 1

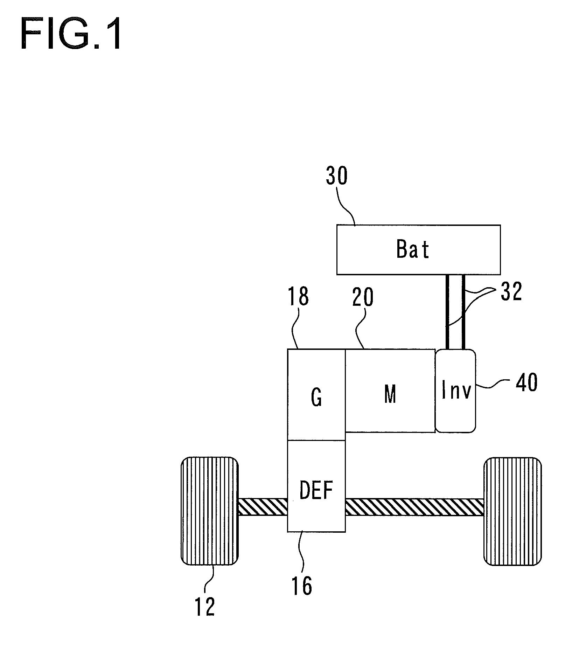

FIG. 1 is a diagram showing a control block of an electric vehicle (hereafter, referred to as "EV"). A motor generator (hereafter, referred to as "motor") 20, which may be, for instance, a permanent magnet synchronous electric motor, has not only a function of generating torque for traveling of a vehicle but also a function of a generator to convert mechanical energy applied from outside to the motor 20 into electric power.

The rotation torque generated by the motor 20 is transmitted to wheels 12 via a reduction gear 18 and a differential gear 16. On the other hand, upon the operation of regenerative braking, the rotation torque is transmitted from the wheels 12 to the motor 20 to generate alternating current power based on the supplied rotation torque. The generated alternating current power is converted into direct current power by an inverter device 40 and charged in a high voltage battery 30. The charged power is used again as traveling energy.

The inverter device 40 is electrically connected to the battery 30 via a direct current cable 32 to allow exchange of power between the battery 30 and the inverter device 40. In case that the motor 20 is used to operate as a motor, the inverter device 40 generates alternating current power based on the direct current power supplied from the battery 30 via the direct current cable 32 and supplies the generated alternating current power to the motor 20.

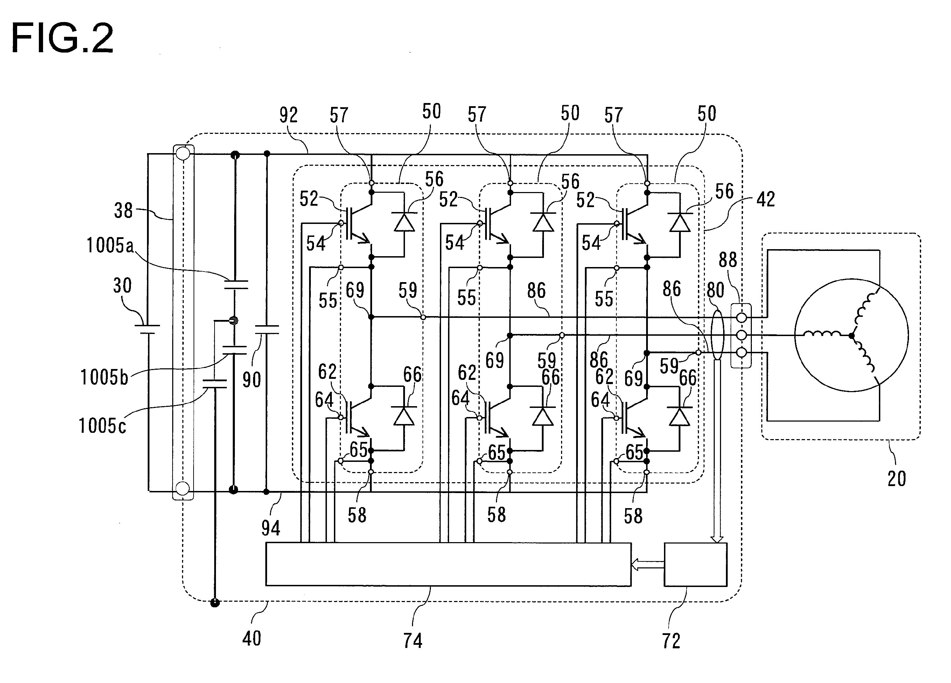

Next, the configuration of an electric circuit of an inverter circuit 42 is explained with reference to FIG. 2. In the following explanation, semiconductor device used is, for example, an insulated gate bipolar transistor (hereafter, referred to as "IGBT" for short).

An IGBT 52 and a diode 56 together operating as an upper arm and an IGBT 62 and a diode 66 together operating as a lower arm constitute a series circuit 50 for the upper and lower arms. The series circuit 50 is provided in the inverter circuit 42 corresponding to each of U-, V-, and W-phases of the AC power.

The U-, V-, and W-phases in this Embodiment 1 correspond, respectively, to windings of three-phases of the armature windings of the motor 20. The series circuit 50 of the upper and lower arms for each of the three-phases outputs alternating current power from an intermediate electrode 69 of the series circuit 50. The configuration in which the intermediate electrode 69 is connected to the winding of each phase of the motor 20 via an alternating current bus bar is explained concretely in Embodiment 5 below.

A collector electrode of the IGBT 52 of the upper arm is electrically connected to a positive conductor plate 92 via a positive terminal 57 and an emitter electrode of the IGBT 62 of the lower arm is electrically connected to a negative conductor plate 94 via a negative terminal 58. The positive conductor plate 92 and the negative conductor plate 94 are electrically connected to a capacitor 90 and further electrically connected to the battery 30 via a DC connector 38.

A control circuit 72 receives a control command from a higher-order control device and based on this control command, generates a pulse width modulation (PWM) signal, which is a control signal to control the IGBT 52 and the IGBT 62 for each phase that constitute the inverter circuit 42, and supplies the generated control signal to a driver circuit 74.

Based on the PWM signal, the driver circuit 74 supplies respective drive signals that control the IGBTs 52 and 62 for each phase to the IGBTs 52 and 62 via a signal emitter electrode 55 and a gate electrode 54 of the IGBT52 and a signal emitter electrode 65 and a gate electrode 64 of the IGBT 62. The IGBTs 52 and 62 for each phase perform conduction or breaking operation based on the drive signal from the driver circuit 74 to convert the direct current power supplied from the battery 30 into three-phase alternating current power and respectively supply the obtained alternating current power to the motor 20.

Capacitors 1005a, 1005b, and 1005c together constitute an electromagnetic compatibility (EMC) filter of star connection (hereafter, referred to as "Y-capacitor), with one terminals of the capacitors being connected together and the other terminals of the capacitors being connected to the positive conductor plate 92, the negative conductor plate 94, and an inverter housing of the inverter device 40, respectively.

The control circuit 72 includes a microcomputer that calculates switching timing of the IGBT 52 and IGBT 62. Information input to the microcomputer includes, for instance, a target torque value required for the motor 20, a current value supplied from the series circuit 50 to the motor 20, and a position of magnetic pole of a rotor of the motor 20.

The target torque value is calculated based on a command signal output from an upper-order control device. The current value is detected based on a detection signal detected by a current sensor 80. The position of the magnetic pole is detected based on a detection signal output from a rotation magnetic pole sensor (not shown) such as a resolver provided in the motor 20.

The microcomputer in the control circuit 72 calculates respective current command values for d-axis and q-axis of the motor 20 based on the target torque value. It also calculates respective voltage command values for d-axis and q-axis based on differences between the respective calculated current command values for d-axis and q-axis and respective detected current values for d-axis and q-axis and then convert the respective calculated voltage command values for d-axis and q-axis into respective voltage command values for U-, V-, and W-phases based on the detected position of the magnetic pole. The microcomputer generates pulsed modulation waves based on comparison between a fundamental wave (sinusoidal wave) and a carrier wave (triangular wave) based on the respective voltage command values for U-, V- and W-phases and outputs the generated modulation wave as a PWM signal to the driver circuit 74.

To drive the lower arm, the driver circuit 74 outputs a drive signal, which is an amplified signal of the PWM signal, to the gate electrode of the IGBT 62 of the corresponding lower arm. To drive the upper arm, the driver circuit 74 shifts the level of the reference potential of the PWM signal to the level of the reference potential of the upper arm and then amplifies the PWM and outputs the amplified PWM signal as a drive signal to the gate electrode of the IGBT 52 of the corresponding lower arm.

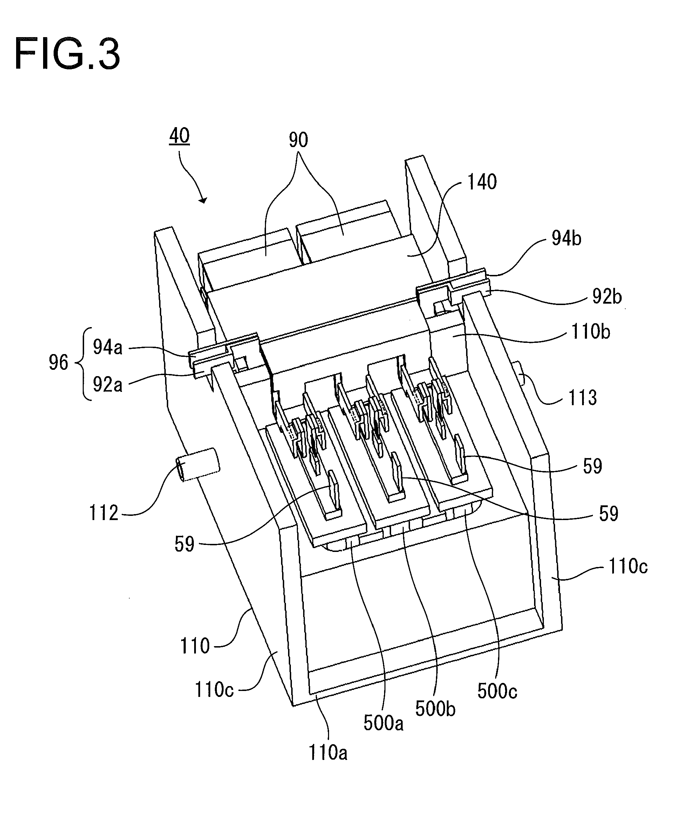

FIG. 3 is an external perspective view showing the inverter device 40 according to Embodiment 1.

As shown in FIG. 3, the inverter device 40 includes an inverter housing 110, the capacitor 90 accommodated in the inverter housing 110, semiconductor modules 500a to 500c, and a DC bus bar 96 that connects the capacitor 90 to the semiconductor modules 500a to 500c. Although the inverter device 40 also includes, for instance, a control circuit board and a lid for the inverter housing 110, these have no direct relation to the present invention and thus are omitted here from the explanation.

The inverter housing 110 includes a bottom plate 110a and side walls 110c, which define a structure having a longitudinal cross-section in a substantially U-shape. The inverter housing 110 also includes an inner wall 110b formed in a direction perpendicular to the side wall 110a. The inner wall 110b separates the capacitor 90 and the semiconductor modules 500a to 500c one from another. On the side of the inverter housing 110 where the semiconductor modules 500a to 500c are stored, a storage room is formed, in which the semiconductor modules 500a to 500c are stored.

The inverter housing 110 is provided with a refrigerant inlet 112, a refrigerant outlet 113, and a refrigerant flow channel. The first, second, and the third semiconductor modules 500a to 500c are cooled with the refrigerant.

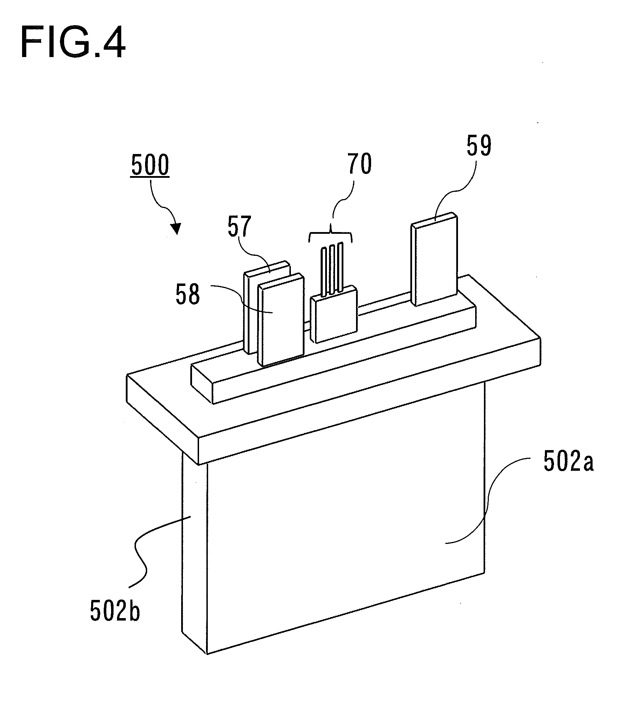

FIG. 4 is an external perspective view showing a semiconductor module 500. The semiconductor modules 500a to 500c have sealed in the inside of the modules power semiconductor devices (IGBT52, IGBT62, diode 56, and diode 66) that constitute the series circuits 50 of the upper and lower arms of U-, V-, and W-phases, respectively. The semiconductor modules 500a to 500c each include external connection terminals such as a positive terminal 57, a negative terminal 58, and an alternating current terminal 59, and a connection terminal 70 for control signals for, such as an upper arm gate terminal 54, an upper arm emitter terminal 55, a lower arm gate terminal 64, and a lower arm emitter terminal 65. Alternating current terminals 59 of the first, second, and third semiconductor modules 500a to 500c, respectively, are connected to a first, second, and third alternating current bus bars, which are not shown in the figures.

Heat generated at the power semiconductor device is mainly discharged from first heat dissipation surfaces 502a and second heat dissipation surfaces 502b of the semiconductor modules 500a to 500c to the refrigerant that flows in a refrigerant flow channel 114. The heat dissipation surfaces 502a and 502b may be provided with a heat dissipation fin, which is columnar or plate-like to increase a contact area with the refrigerant.

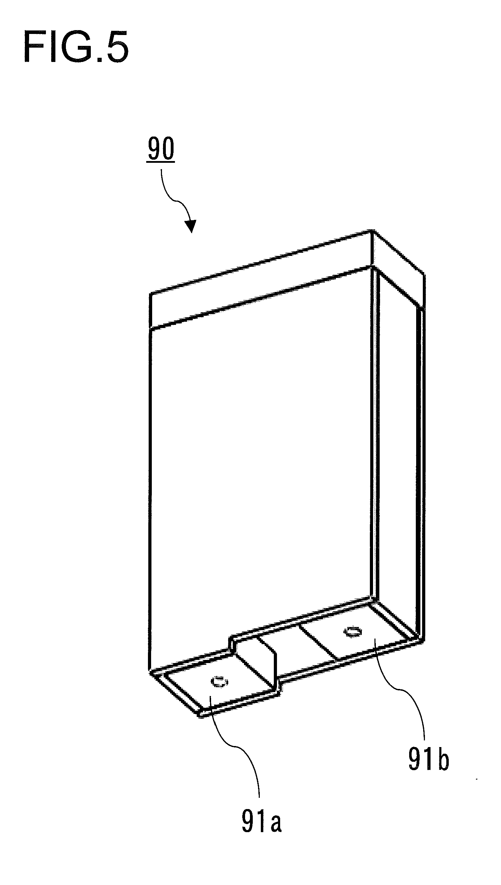

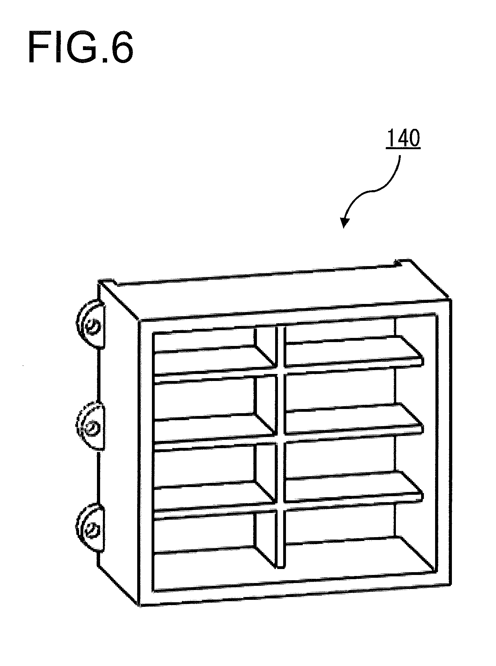

As shown in FIG. 5, the capacitor 90 has a substantially rectangular shape and has a positive terminal 91a and a negative terminal 91b on the bottom. As shown in FIG. 6, a capacitor storage case 140 has a grid-like form. Each grid stores one capacitor 90 as shown in FIG. 5. It is preferred that the capacitor 90 be fixed to the storage case 140. However, the storage case 140 may be filled with a mold resin to fix the capacitor 90.

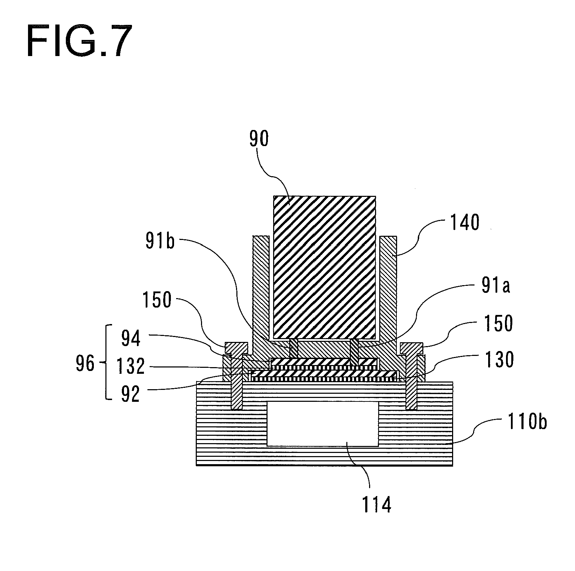

FIG. 7 is a cross-sectional view showing the inner wall 110b and the capacitor 90 side. As shown in FIG. 7, the refrigerant flow channel 114 is provided in the inner wall 110b that the DC bus bar 96 contacts via an insulating member 130.

The capacitor storage case 140 that also serves as a bus bar support member is arranged in contact with the DC bus bar 96, and inside the capacitor storage case 140 is stored the capacitor 90. The capacitor storage case 140 is fixed to the inverter housing 110 with a fixing member 150, such as a screw, to cause the DC bus bar 96 to be pressed against the inner wall 110b. The positive terminal 91a and the negative terminal 91b of the capacitor 90 are arranged to penetrate the bottom of the storage case 140 to be electrically connected to the positive conductor plate 92 and the negative conductor plate 94, respectively.

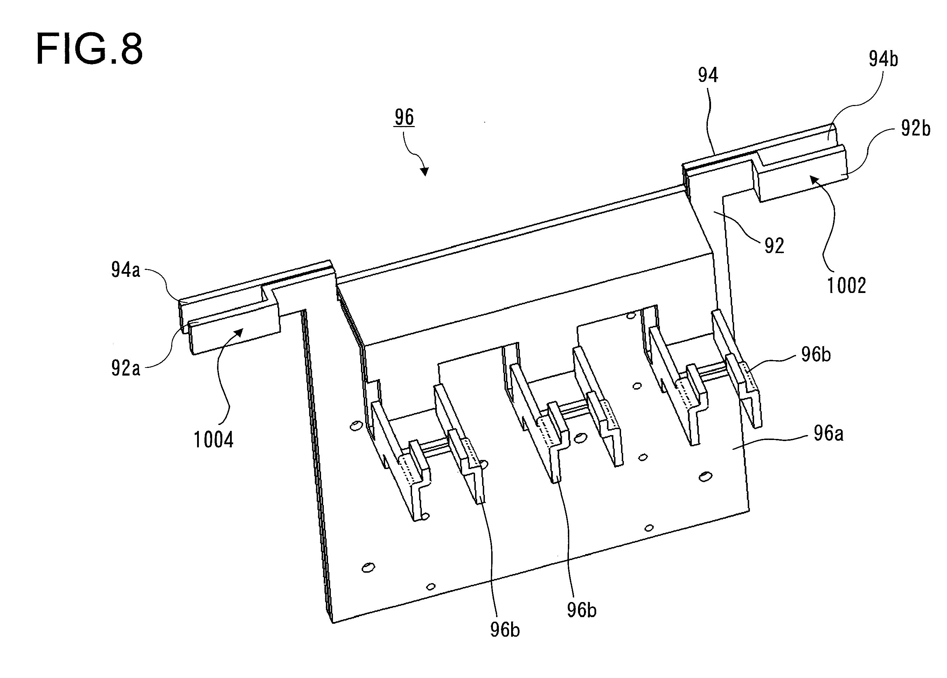

FIG. 8 is an external perspective view representing structural features of the DC bus bar 96 in the inverter 40. The DC bus bar 96 is an insulation laminate constituted by the positive conductor plate 92, the negative conductor plate 94, and an insulating member 132 interposed between the positive conductor plate 92 and the negative conductor plate 96. The DC bus bar 96 includes a planar section 96a formed relatively wide along the inner wall 110b, connection sections 96b that are folded back from the planar section 96a toward the semiconductor modules 500a to 500c to be connected to the respective semiconductor modules 500a to 500c, and pull-out sections 92a, 92b, 94a, and 94b, which are extensions of both lateral edges of the planar section 96a. The inverter device 40 according to Embodiment 1 is featured by having two pairs of the pull-out sections (92a and 94a; 92b and 94b).

The planar section 96a is pressed against the inner wall 110b of the inverter housing 110 via an insulating member that is not shown in the figures. The inner wall 110b serves as a cooling surface that cools the DC bus bar 96 by means of the refrigerant flow channel 114 as described above referring to FIG. 3.

The positive conductor plate 92 that constitutes the DC bus bar 96 is electrically connected to the positive terminals 57 of the semiconductor modules 500a to 500c at the connection sections 96b. The negative conductor plate 94 is electrically connected to the negative terminals 58 of the semiconductor modules 500a to 500c at the connection sections 96b.

The pull-out section 92b of the positive conductor plate 92 and the pull-out section 94b of the negative conductor plate 94 are defined to be first positive and negative terminals 1002 and the pull-out section 92a of the positive conductor plate 92 and the pull-out section 94a of the negative conductor plate 94 are defined to be second positive and negative terminals 1004. The first positive and negative terminals 1002 and the second positive and negative terminals 1004 extend from the side walls 110c in the inverter housing 110.

As shown above, in the inverter device 40 according to Embodiment 1, the first positive and negative terminals 1002 and the second positive and negative terminals 1004 to be connected to an external power source are provided projecting from the DC bus bar 96 in opposite directions. This enables selection of either one of the first positive and negative terminals 1002 and the second positive and negative terminals 1004 to connect to a direct current cable that is connected to the external power source. Thus, the pull-out direction for the direct current cable can be modified without changing the shape of the motor and the shape of the inverter device body. As a result, the packaging volume including direct current cable can be reduced.

The direct current cable is allowed to be connected to either one selected from the first positive and negative terminals 1002 and the second positive and negative terminals 1004. This facilitates installment of the direct current cable.

No need for changing the shape of the motor or the shaped of the inverter device body increases mass-producibility and productivity, which allows reduction of cost of parts.

### Embodiment 2

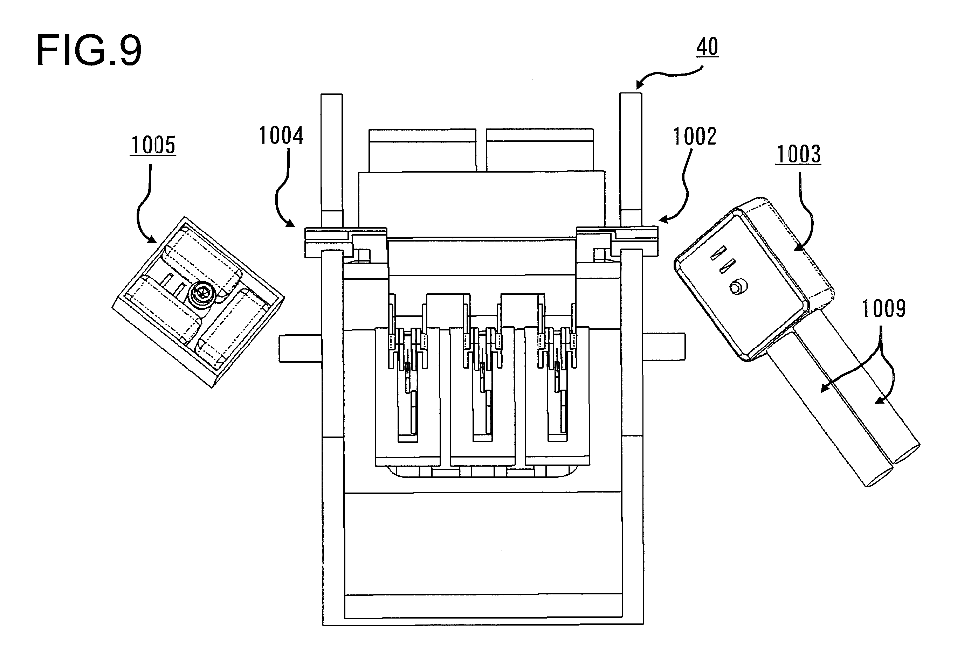

An inverter device according to Embodiment 2 of the present invention is explained with reference to FIG. 9. In Embodiment 2, as shown in FIG. 9, a DC connector 1003 is connected to the first positive and negative terminals 1002 of the inverter device 40 to allow connection to a direct current cable 1009 and a Y-capacitor 1005 to cope with EMC is connected to the second positive and negative terminals 1004.

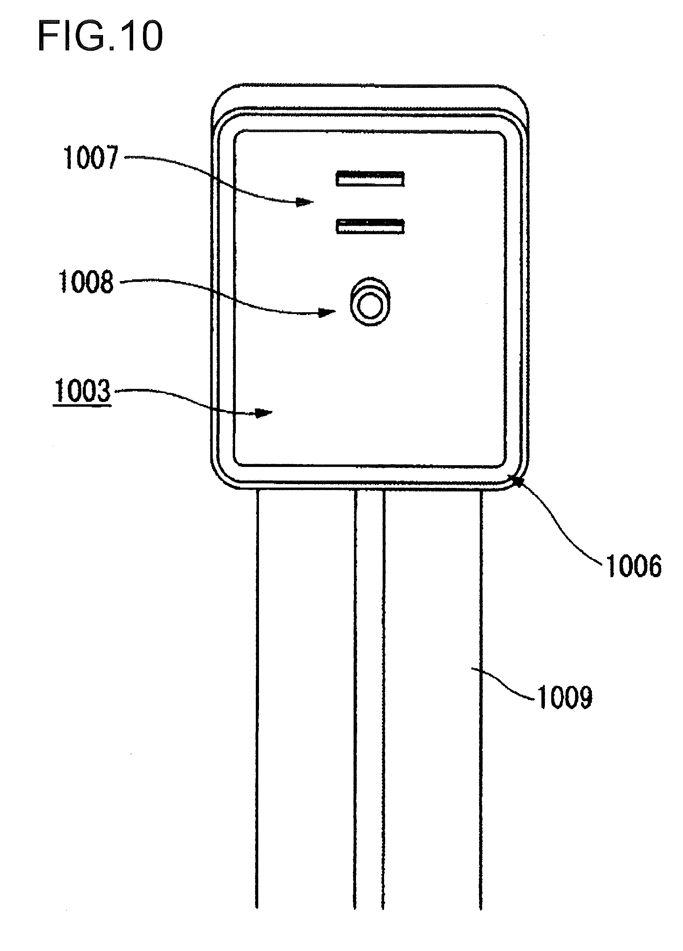

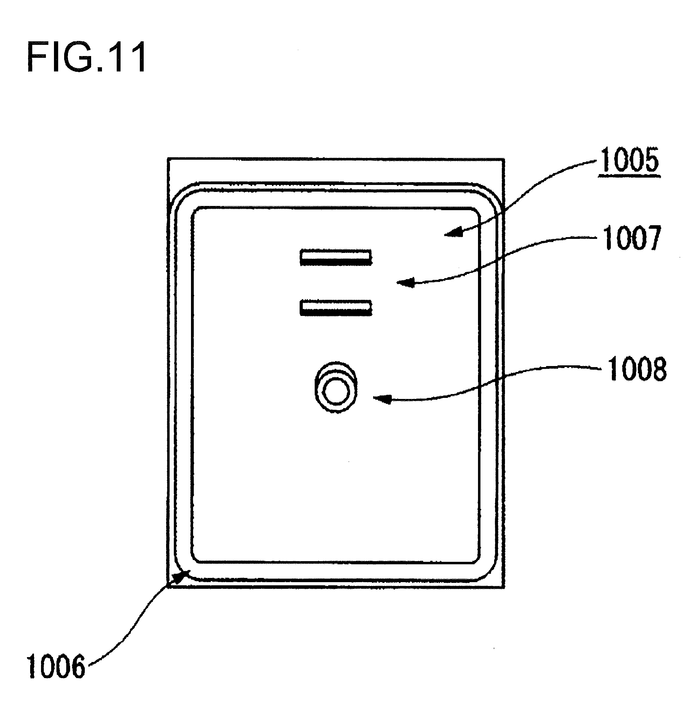

FIG. 10 is an external view of the DC connector 1003 and FIG. 11 is an external view of the Y-capacitor 1005.

The DC connector 1003 and the Y-capacitor 1005 have the same surface configuration at the surface at which they are connected to the inverter device 40 (hereafter, this surface being referred to as "bottom surface") and are each provided with an O-Ring 1006 to make them waterproof and dustproof. On each bottom surface of the DC connector 1003 and the Y-capacitor 1005, a DC terminal connection section 1007, which is connected to the first positive and negative terminals 1002 (or second positive and negative terminals 1004), is formed and a nail or screw 1008 for connection that maintains the state of connection to the inverter device 40 is provided.

By connecting the DC terminal connection section 1007 of the DC connector 1003 shown in FIG. 10 to the first positive and negative terminals 1002, the direct current cable 1009 is connected to the DC bus bar 96. By connecting the DC terminal connection section 1007 of the Y-capacitor 1005 shown in FIG. 11 to the second positive and negative terminals 1004, the Y-capacitor 1005 is connected to the DC bus bar 96. Then, the DC connector 1003 and the Y-capacitor 1005 are fixed to the inverter device 40 (inverter housing 110) with the nail or screw 1008 for connection.

The above configuration enables the DC connector 1003 and the Y-capacitor 1005 to be connected interchangeably. That is, it is possible to connect the DC connector 1003 to the second positive and negative terminals 1004 and the Y-capacitor 1005 to the first positive and negative terminals 1002. This interchangeability between the DC connector 1003 and the Y-capacitor 1005 enables the inverter device 40 to select the DC connector 1003 for connecting to the external power source to be attached either at the right or left side of the inverter housing 110, thus considerably increasing the freedom of layout of the on-vehicle components.

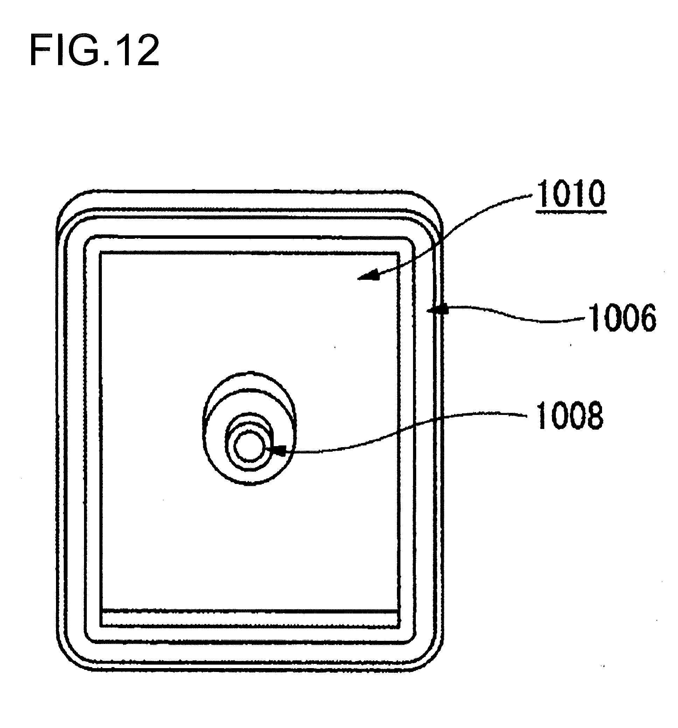

FIG. 12 is an external view of a terminal cover 1010 for safety. The terminal cover 1010 has a bottom surface that is similar to the bottom surfaces of the DC connector 1003 and the Y-capacitor 1005. The terminal cover 1010 has an O-Ring 1006 for preventing water and dust and a nail or screw 1008 for connection. A terminal connection section 1007 is not provided.

The terminal cover 1010 allows interchanging connection or substituting connection to the DC connector 1003 or the Y-capacitor 1005. Thus, in case that any one of the two pairs of the first positive and negative terminals 1002 and of the second positive and negative terminals 1004 is unused, the terminal cover 1010 may be connected to the unused pair of positive and negative terminals to prevent exposure of the unused pair of positive and negative terminals.

This enables safety to be secured and the freedom in designing the layout to be increased further.

### Embodiment 3

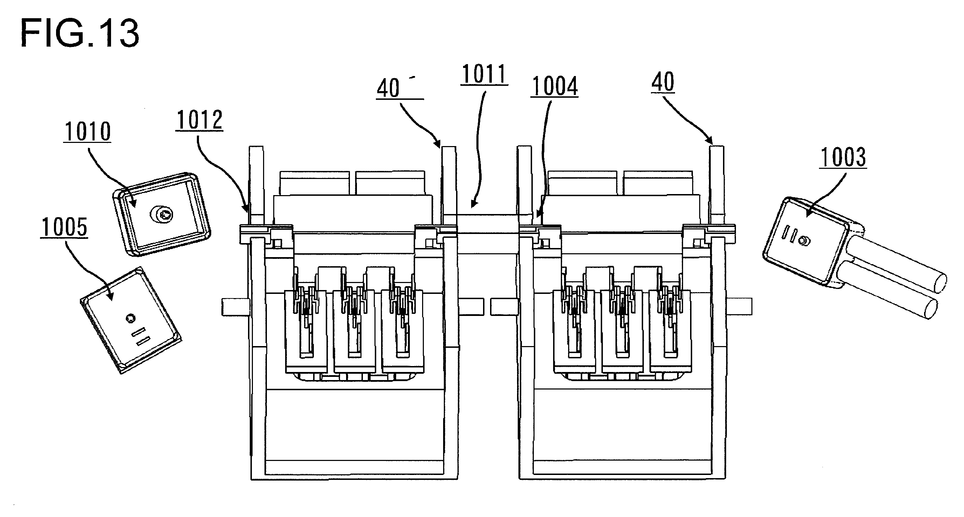

Next, an inverter device according to Embodiment 3 of the present invention is explained with reference to FIG. 13.

In Embodiment 3, as shown in FIG. 13, the DC connector 1003 is connected to the first positive and negative terminals 1002 of the inverter device 40 and an additional inverter device 40' is connected to the second positive and negative terminals 1004 of the inverter device 40.

As shown in FIG. 13, in order to connect the additional inverter device 40', a coupling member 1011 is necessary since the second positive and negative terminals 1004 of the inverter device 40 and the first positive and negative terminals 1002 of the additional inverter device 40' are all male terminals. To the second positive and negative terminals 1004, which are unconnected, of the last additional inverter 40', may be connected the Y-capacitor 1005 or the terminal cover 1010. In the configuration shown in FIG. 13, the additional inverter 40' is connected to the side of the second positive and negative terminals 1004 of the inverter device 40. However, the additional inverter 40' may be connected to the first positive and negative terminals 1002 of the inverter device 40.

Parts other than the additional inverter 40 that are connectable to a DC line (i.e., functionality expansion modules), for instance, a DC/DC converter, an additional DC capacitor, and a battery, may be connected to the second positive and negative terminals 1004 of the inverter device 40. That is, the functionality of the inverter can be expanded like building blocks.

In the same manner as that in Embodiment 2, a layout designer may freely select the side of the terminal to which the direct current cable 1003, the additional inverter 40' or the like is connected. This increases the freedom in designing the layout.

### Embodiment 4

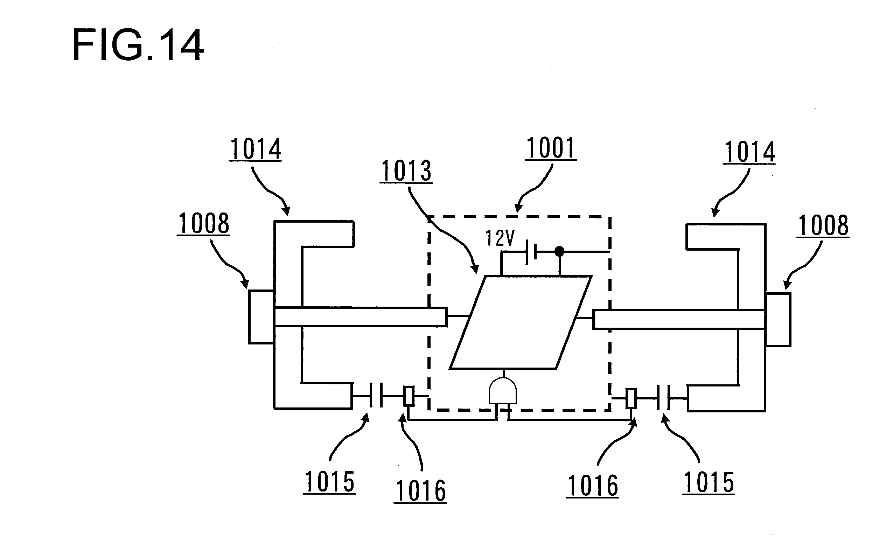

Next, an inverter device according to Embodiment 4 is explained with reference to FIG. 14.

FIG. 14 is a diagram showing an electrostatic coupling type detection means to confirm whether an additional module such as the direct current cable 1003 or the terminal cover 1010 is properly connected to the inverter device 40 (hereafter, referred to as "judgment system"). This judgment system is to secure functional safety such as prevention of electric shock.

After additional modules (a DC harness 1003 and the like) are connected to the first positive and negative terminals 1002 and to the second positive and negative terminals 1004, a connection judgment circuit 1013 outputs a confirmation signal. This confirmation signal travels from the connection nail or screw 1008 for connection to the inverter device 40 via a housing 1014 of the additional module or the like and returns to the judgment circuit 1013 via a floating capacitor 1015 generated between the housing 1014 of the additional module or the like and the inverter housing 110. Then, the current flowing in the floating capacitor 1015 is detected by a current sensor 1016. On this occasion, if the additional module or the like is properly connected, current is detected and it is judged that the system is safe. If proper connection is not confirmed at both the terminals, this condition is notified to a control device of the vehicle, which is not shown in the figures, through network type communication means, such as controller area network (CAN). Other measures such as inactivation of the inverter device 40 or cutting off of strong electric relays may be taken. The connection judgement circuit 1013 operates with a voltage of a low current system of the inverter. This eliminates electric shock while the judgment circuit 1013 is operating.

As described above, according to Embodiment 4, it is possible to detect whether the state of attachment of components is proper upon connection of an additional module to the inverter device 40 or rearrangement of additional modules, etc., required when modifying the direction of pulling out the direct current cable 1003.

This enables system health and safety relating to prevention of electric shock, etc. to be secured.

### Embodiment 5

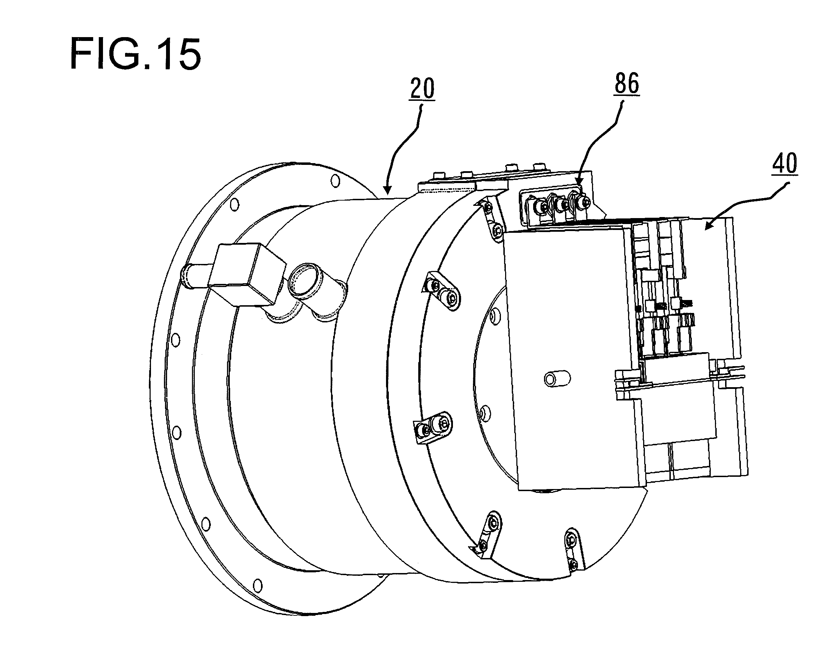

Next, an inverter device according to Embodiment 5 of the present invention is explained with reference to FIG. 15.

FIG. 15 is a perspective view showing the arrangement of the inverter device 40 and the motor 20 that are mechanically and electrically integrated together. In this embodiment, an AC connection harness is removed and the connection is achieved through an AC bus bar 86.

The inverter device 40 in Embodiments 1 to 4 may be adopted in the mechanically and electrically integrated configuration of this embodiment. In the mechanically and electrically integrated configuration, the direction in which the inverter device 40 is installed is fixed depending on the shape of the motor. This would possibly reduce freedom in designing the layout of on-vehicle components significantly depending upon the position at which the direct current cable 1003 is connected.

However, the inverter device 40 according to any of Embodiments 1 to 4, in which the side at which the DC harness 1003 is connected is selectable, enables the freedom in designing the layout of on-vehicle components to be maintained or only slightly reduced.

As described above, only concrete examples are explained in detail. However, it is obvious to one skilled in the art that various changes and modifications may be made within the technical concept of the present invention and such changes and modifications shall be within the scope of claims of the present application.

Although the system of an inverter integrated with a motor for driving an electric vehicle is referred to in Embodiments 1 to 5, the present invention is not limited to these embodiments and the present invention may be adopted in, for instance, a hybrid vehicle or in a system in which the motor and the inverter are separately arranged.

### REFERENCE SIGNS LIST

- 20: motor generator (motor)
- 30: battery (external power source)
- 32: direct current cable
- 40: inverter device
- 90: smoothing capacitor
- 96: DC bus bar
- 110: inverter housing
- 500: semiconductor module
- 1002: first positive and negative terminals
- 1003: DC connector
- 1004: second positive and negative terminals
- 1005: Y-capacitor
- 1010: terminal cover

## Claims

1. An inverter device that controls output of a motor, the inverter device comprising:
an inverter housing;
a smoothing capacitor and a semiconductor module that are stored in the inverter housing; and
a DC bus bar that connects the smoothing capacitor to the semiconductor module and is provided with two pairs of positive and negative terminals connectable to an external power source, wherein:
the two pairs of the positive and negative terminals, respectively, project from different side surfaces of the inverter housing.

2. The inverter device according to claim 1, wherein:
the inverter housing is constituted by a bottom plate and side walls to have a longitudinal cross-section in a substantially U-shape, and includes an inner wall formed to be perpendicular to the side walls to separate the smoothing capacitor and the semiconductor module one from another;
the DC bus bar includes
a planar section made of an insulation laminate arranged along the inner wall of the inverter housing,
a connection section that extends from the planar section and is connected to the semiconductor module, and
the two pairs of the positive and negative terminals that extend from respective side edges of the planar section and project through the side walls of the inverter housing; and
one pair of the two pairs of the positive and negative terminals is connected to a direct current cable that is connected to an external power source.

3. The inverter device according to claim 2, wherein:
another pair of the two pairs of the positive and negative terminals is sealed with a terminal cover that is interchangeable with the direct current cable or is connected to a Y-connected capacitor that is interchangeable with the direct current cable.

4. The inverter device according to claim 2, wherein:
another pair of the two pairs of the positive and negative terminals is connected to an additional inverter device through a coupling member.

5. The inverter device according to claim 2, wherein:
another pair of the two pairs of the positive and negative terminals is connected to a functionality expansion module connectable to a DC line.

6. The inverter device according to any one of claims 2 to 5, further comprising:
an electrostatic detection means that detects whether a direct current cable connected to an external power source, a terminal cover, or a Y-connected capacitor is properly connected to the positive and negative terminals.

7. An inverter device integrated with a motor, that is fastened to a motor case and controls output of the motor, the device comprising:
an inverter housing fastened to the motor case;
a smoothing capacitor and a semiconductor module stored in the inverter housing; and
a DC bus bar that connects the smoothing capacitor to the semiconductor module and is provided with two pairs of positive and negative terminals connectable to an external power source, wherein:
the two pairs of the positive and negative terminals, respectively, project from different side surfaces of the inverter housing.

8. The inverter device integrated with a motor according to claim 7, wherein:
the inverter housing is constituted by a bottom plate and side walls to have a longitudinal cross-section in a substantially U-shape, and includes an inner wall formed to be perpendicular to the side walls to separate the smoothing capacitor and the semiconductor module one from another;
the DC bus bar includes
a planar section made of an insulation laminate arranged along the inner wall of the inverter housing,
a connection section that extends from the planar section and is connected to the semiconductor module, and
the two pairs of the positive and negative terminals that extend from respective side edges of the planar section and project through the side walls of the inverter housing; and
the one pair of the two pairs of the positive and negative terminals is connected to a direct current cable that is connected to an external power source.

9. The inverter device integrated with a motor according to claim 8, wherein:
the other pair of the two pairs of the positive and negative terminals is sealed with a terminal cover that is interchangeable with the direct current cable or is connected to a Y-connected capacitor that is interchangeable with the direct current cable.

10. The inverter device integrated with a motor according to claim 8, wherein:
the other pair of the two pairs of the positive and negative terminals is connected to a functionality expansion module connectable to a DC line.

11. The inverter device integrated with a motor according to claim 8, wherein:
the other pair of the two pairs of the positive and negative terminals is connected to an additional inverter device through a coupling member.

12. The inverter device integrated with a motor according to any one of claims 8 to 11, further comprising:
an electrostatic detection means that detects whether a direct current cable connected to an external power source, a terminal cover, or a Y-connected capacitor is properly connected to the positive and negative terminals.
